# EUROPÄISCHE PATENTANMELDUNG

(11) **EP 0 673 191 A1**
(43) Veröffentlichungstag der Anmeldung: **20.09.1995**
(21) Anmeldenummer: 95103686.2
(22) Anmeldetag: 14.03.1995
(51) Int. Cl.: H05K 7/14

(54) **Träger für einschiebbare elektrische Baugruppen**

(30) Priorität: 16.03.1994 DE 4409024
(71) Anmelder: SIEMENS AKTIENGESELLSCHAFT, D-80333 München (DE)
(72) Erfinder: Beier, Jürgen, Dipl. Ing., D-17438 Mahlzow (DE); Schulz, Michael, Dipl. Ing., D-13059 Berlin (DE); Just, Ulrich, Dipl. Ing., D-17491 Greifswald (DE); Szybalski, Michael, Dipl. Ing., D-12169 Berlin (DE)

(57) **Zusammenfassung**

Waagerechte Böden (4) mit Führungsnuten für die Baugruppen waren bisher über Rahmenteile des Baugruppenträgers miteinander verbunden.

Nach der Erfindung sind die Böden (4) verschiedener Ebenen durch eine senkrechte Tragwand (5) einstückig miteinander zu einem Formteil (1) verbunden, das kostengünstig herstellbar ist.

## Beschreibung

Die Erfindung bezieht sich auf einen Baugruppenträger für einschiebbare elektrische Baugruppen mit in tragenden Böden eingeformten Führungsnuten für die Baugruppen.

Es ist bekannt, einschiebbare Baugruppen zwischen plattenartigen Böden zu führen, die mit Führungsnuten für die Leiterplatten versehen sind. Derartige Böden sind üblicherweise in einen aus Profilschienen zusammengesetzten Tragrahmen eingesetzt. Beim Einsatz von unterschiedlichen hohen Baugruppen in einem Baugruppenträger müssen Zwischenböden verwendet werden, die zusätzliche Tragelemente benötigen.

Ferner ist durch die DE-AS 23 48 687 ein Gehäuse für einschiebbare elektrische Baugruppen bekannt geworden, das aus einem kastenförmigen, Formteil besteht, in dessen Seitenwänden die Führungsnuten für die Baugruppen ausgebildet sind. An die offene Rückseite des Formteils ist eine Rückwandverdrahtungsplatte angesetzt. Zusätzliche Zwischenwände mit zusätzlichen Führungsnuten unterteilen das Gehäuse in unterschiedlich große Aufnahmeräume für unterschiedlich hohe Baugruppen. Dabei sind die Zwischenwände z.T. beidseitig mit Führungsnuten versehen. Durch die einstückige Verbindung zwischen den Böden der verschiedenen Ebenen entsteht ein formstabiler Körper, der alle wichtigen Zuordnungen enthält.

Ferner ist nach der DE-OS 22 29 173 ein Gehäuse aus zwei Halbschalen Zusammengesetzt, die als Fließpressteile ausgebildet sind, bei denen die Führungsnuten für die Baugruppen ebenfalls in den Gehäusewänden ausgeformt sind. Zwischenwände unterteilen das Gehäuse in unterschiedlich bemessene Aufnahmeräume.

Nach der US 3,289,852 besteht ein Gehäuse aus einem stranggepressten Rechteckrohr in das jeweils eine Baugruppe in diagonaler Lage einschiebbar ist, wobei in den Innenecken des Gehäuses Führungsnuten für die Baugruppe vorgesehen sind.

Nach der DE 35 29 360 C2 ist ein Baugruppengehäuse ebenfalls aus einem Strangpreßprofil gebildet, das mit Führungen für die Baugruppen versehen ist.

Nach der DE 28 33 043 besteht ein Baugruppengehäuse aus einem rohrförmigen Strangpreßprofil, an dessen Innenwänden die Führungsnuten für die Baugruppen ausgeformt sind.

Nach der DE 37 32 886 C1 ist ein stranggepresstes rohrfömiges Gehäuse mit umlaufend angeordneten Führungsnuten durch einschiebbare Zwischenböden in mehrere Teilgehäuse unterteilbar, in die unterschiedlich hohe Baugruppen einschiebbar sind.

Der Erfindung liegt die Aufgabe zugrunde, einen Baugruppenträger zu schaffen, der einfach aufgebaut, kostengünstig herstellbar, und variabel mit Baugruppen unterschiedlicher Höhe und Teilmengen bestückbar ist.

Diese Aufgabe wird durch die Erfindung gemäß Anspruch 1 gelöst. Der Baugruppenträger besteht nun im wesentlichen aus einem Gehäuse mit der Rückwandverdrahtungsplatte und den einstückigen, in sich stabilen Formteilen, an denen die einzelnen Böden ohne jeden Montageaufwand maßgenau ausgebildet sind. Durch die Trennung des Gehäuses von den Formteilen ist es möglich, sie einzelnen Teile optimal auf ihre Aufgaben abzustimmen.

Die Gehäusewände können nun aus eng vorgelochten Blechen gebildet werden, die eine sichere Schirmung und gute Belüftung des Innenraums ermöglichen.

Die Formteile weisen keine Außenwände auf und können somit im Querschnitt erheblich kleiner gehalten und kostengünstig aus Strangpreßprofil hergestellt werden.

Das Gehäuseinnere kann nun durch unterschiedliche Formteile und/oder durch unterschiedlich zusammengesetzte Formteile mit geringem Herstellungs-, und Montageaufwand flexibel in unterschiedlich große Aufnahmeräume für unterschiedlich hohe Baugruppen unterteilt werden. Dadurch können z.B. Geräte der Kommunikationstechnik in einfacher Weise mit einer geringen Anzahl von Basisteilen an unterschiedliche Vermittlungsaufgaben angepaßt werden.

Die freiragende Befestigung der Formteile an Befestigungslöchern der entsprechend stabil abgestützten Rückwandplatte ermöglicht mit geringem Aufwand eine freizügige Anordnung der Formteile im Baugruppenträger.

Vorteilhafte Weiterbildungen der Erfindung sind in den Ansprüchen 2 bis 14 gekennzeichnet:
Durch die Weiterbildung nach Anspruch 2 können in einfacher Weise unterschiedlich hohe Baugruppen in einem Formteil aufgenommen werden.

Die Zwischenböden nach Anspruch 3 dienen sowohl der Führung der darüberliegenden wie auch der darunterliegenden Baugruppen.

Die Weiterbildung nach Anspruch 4 ermöglicht es, auch die Außenseiten der Formteile zur Führung von Baugruppen auszunutzen.

Durch die Weiterbildung durch Anspruch 5 ist es möglich, bei geringen Querschnittsabmessungen der Formteile neben niedrigen Baugruppen auch relativ hohe Baugruppen aufzunehmen.

Das Strangpreßprofil nach Anspruch 6 läßt sich besonders kostengünstig herstellen. Die Formteile werden einfach durch Abschneiden von der Profilstange gewonnen. Unterschiedlich lange Baugruppen erfordern unterschiedliche Einbautiefe, die durch entsprechende Schnittlänge von der Profilstange erreicht wird. Die Befestigungsöffnungen können z.B. als teilweise geöffnete gepreßte Befestigungskanäle ausgebildet sein, in die Befestigungsschrauben für die Rückwandverdrahtungsplatte einschraubbar sind.

Durch die Weiterbildung der Ansprüchen 7 bis 9 werden die Formteile gegeneinander so stabilisiert, daß sie mechanisch wie ein einziges behandelt werden können. Aus diesem Grunde werden keine weiteren Stabilisierungselemente benötigt. Die Einheit bedarf keiner besonderen Stabilisierung durch das Gehäuse, so daß dieses einfacher gestaltet werden kann.

Die Weiterbildung nach den Ansprüchen 10 und 11 ermöglicht eine einfache Montage des Gehäuses. Die teilweise offenen Befestigungskanäle lassen sich einfacher herstellen als geschlossene. Sie sind im Querschnitt z.B. omega-artig ausgebildet. Die mit Querrillen versehenen Ziehnieten haben beim Einsetzen zunächst einen geringeren Durchmesser als der Befestigungskanal. Durch Hindurchziehen eines am Ende verdickten Stiftes werden die Nieten aufgeweitet, so daß sie sich mit ihren Querrillen fest in den Strangpreßteilen verkrallen.

Durch die Weiterbildung nach den Ansprüchen 12 und 13 kann die Baueinheit in einfacher Weise am Halterahmen befestigt werden. Es werden keine Befestigungslöcher an den Rahmenteilen benötigt. Die Baueinheiten können in beliebiger Breite und Verteilung aneinandergereiht werden. Dadurch ist es besonders vorteilhaft, Funktionseinheiten unterschiedlicher Übertragungsstufen gemäß Anspruch 16 in einem Halterahmen zusammenzufassen.

Im folgenden wird die Erfindung anhand eines in der Zeichnung dargestellten Ausführungsbeispieles näher erläutert. Es zeigen:
- Figur 1: eine perspektivische Ansicht zweier Formteile zur Aufnahme elektrischer Baugruppen mit einer Rückwandverdrahtungsplatte,
- Figur 2: ein Gehäuse zur Aufnahme der Formteile nach Figur 1 mit einem Halterahmen,
- Figur 3: einen Teilschnitt durch Außenwände des Gehäuses nach Figur 2 mit einem Befestigungselement.

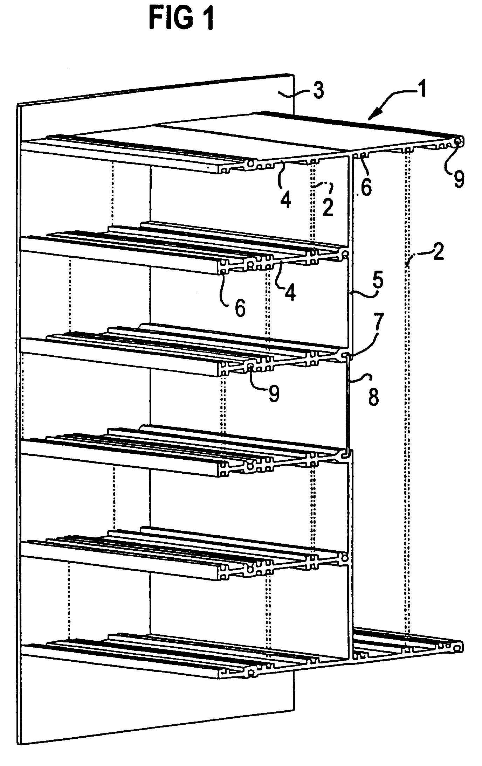

Nach Figur 1 sind von einem Strangpreßprofil abgeschnittene Formteile 1 zur Aufnahme von einschiebbaren elektrischen Baugruppen 2 an eine Rückwandverdrahtungsplatte 3 angeschraubt. Die Formteile 1 weisen sich waagerecht erstreckende Böden 4 auf, die einstückig mit einer mittleren Tragwand 5 verbunden sind. Die Böden 4 sind mit eingepreßten Führungsnuten 6 versehen, in denen die Leiterplatten der Baugruppen 2 geführt sind. Die übereinander angeordneten Formteile 1 sind auf einer Seite der Tragwand 5 mit nur einem äußeren Boden 4 versehen. Auf der anderen Seite sind mehrere Böden 4 angeordnet zwischen denen sich Einbauräume für niedrigere Baugruppen 2 ergeben.

Die baugleichen Formteile 1 sind spiegelbildlich auf Umschlag so übereinander angeordnet, daß sich auf einer Seite ein großer Einbauraum für hohe Baugruppen zwischen den beiden äußeren Böden ergibt. Die zusätzlichen Böden 4 auf der anderen Seite der Tragwand 5 sind beidseitig mit Führungsnuten 6 versehen, so daß in ihnen unmittelbar Baugruppen 2 zweier Ebenen geführt werden können. Zwischen den einander zugewandten Böden 4 der beiden Formteile 1 können ebenfalls Baugruppen 2 eingesetzt werden.

Im Eckbereich zwischen diesen Böden 4 und den Tragwänden 5 sind im Querschnitt hakenförmige Längsrillen 7 eingeformt, in die die abgewinkelten Seitenschenkel einer u-förmig gebogenen Verstärkungsplatte 8 eingeschoben sind. Diese stabilisiert die beiden Formteile 1 zueinander. Neben den Führungsnuten 6 sind in die Böden teilweise offene Befestigungskanäle 9 eingepreßt, die dem Anschrauben der Rückwandverdrahtungsplatte 3 dienen.

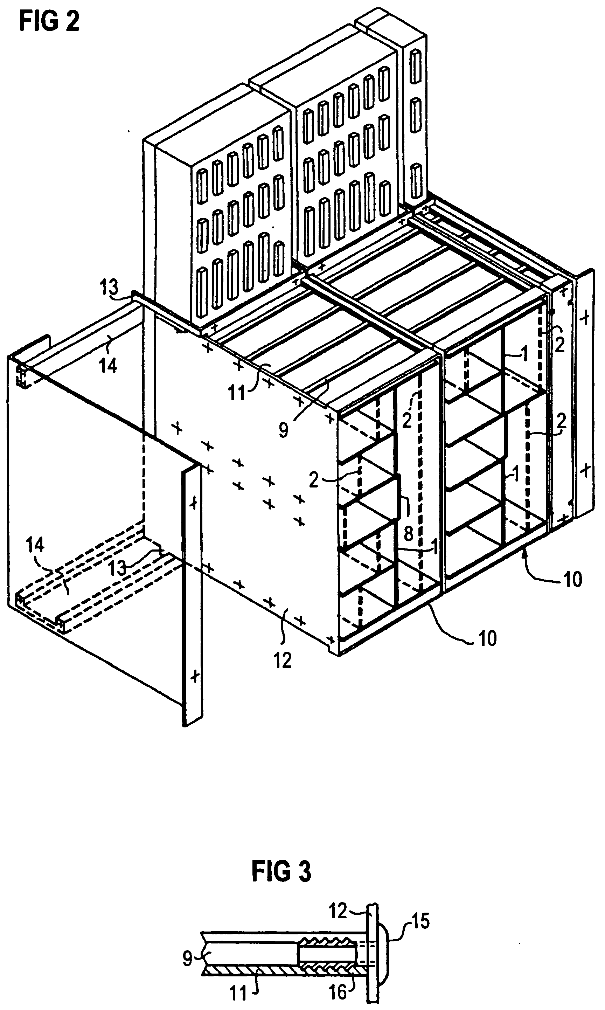

Nach Figur 2 sind die Formteile 1 im Gehäuse 10 eingesetzt. Dabei sind in einem der Gehäuse unterschiedliche Typen von Formteilen 1 derart angeordnet, daß sich mehrere unterschiedliche Einbauhöhen für die Baugruppen 2 ergeben. Die Gehäuse 10 weisen an ihren Ober- und Unterseiten als Strangpreßteile ausgebildete Begrenzungswände 11 auf, deren Profilrichtung sich quer zur Einschubrichtung der Baugruppen 2 erstreckt. Sie sind ebenfalls mit Befestigungskanälen für Seitenwände 12 der Gehäuse 10 versehen.

Die Gehäuse 10 weisen rückseitig hakenartige und nockenartige Vorsprünge 13 auf, mit denen sie in Befestigungsschienen 14 eines Halterahmens eingehängt sind.

Figur 3 zeigt die mechanische Verbindung zwischen einer der Seitenwände 12 und der oberen Begrenzungswand 11 des Gehäuses 10. Die aus Strangpreßprofil bestehende Begrenzungswand ist mit durchgehend eingeformten Befestigungskanälen 9 versehen, in die von beiden Seiten her Ziehnieten 15 einsetzbar sind. Diese sind im Angriffsbereich zum Befestigungskanal 9 mit gewindeartigen Querrippen 16 versehen, deren äußerer Durchmesser, als der Durchmesser des Befestigungskanals 9. Durch Hindurchziehen eines Stifts mit verdicktem Kopf durch die innere Bohrung der Ziehnieten 15 werden diese aufgeweitet, so daß sich die Querrippen 16 in die Begrenzungswand 11 eingraben, was eine sichere Befestigung der Seitenwand 12 ermöglicht.

## Patentansprüche

1. Baugruppenträger mit einem durch Zwischenwände (z.B. 4,5) in verschiedene Aufnahmeräume unterteilten Gehäuse (10) für unterschiedlich hohe einschiebbare elektrischen Baugruppen (3), wobei der Baugruppenträger in waagerechte Böden (4) eingeformte Führungsnuten (6) für die Baugruppen (3) aufweist, und wobei die Böden (4) zumindest Zweier übereinanderliegender Führungsebenen mittels zumindest einer senkrechten Tragwand (5) einstückig miteinander zu einem Formteil (1) verbunden sind,
**dadurch gekennzeichnet,**
daß die Tragwand (5) und die Böden(4) ein vom Gehäuse getrenntes einstückiges Formteil (1) bilden,
daß das Formteil (1) freiragend mittels integrierter Montageöffnungen (z.B. 9) an einer Rückwandverdrahtungsplatte (3) des Baugruppenträgers befestigt ist und
daß unterschiedliche Typen von Formteilen (1) mit unterschiedlich verteilten Böden (4) miteinander zu einer Vielzahl von unterschiedlichen Aufnahmen für unterschiedlich hohe Baugruppen (2) kombinierbar sind.

2. Baugruppenträger nach Anspruch 1,
**dadurch gekennzeichnet,**
daß die Tragwand (5) als Zwischenwand ausgebildet ist und daß die Böden (4) zu beiden Seiten der Tragwand (5) in unterschiedlicher Verteilung angeordnet sind.

3. Baugruppenträger nach Anspruch 1 oder 2,
**dadurch gekennzeichnet,**
daß die Böden 4 beidseitig mit den Führungsnuten (6) versehen sind.

4. Baugruppenträger nach Anspruch 1, 2 oder 3,
**dadurch gekennzeichnet,**
daß zwei übereinander angeordnete Formteile (1) auf den einander zugewandten Seiten Führungsnuten (6) aufweisen, und daß zwischen den beiden Formteilen (1) einschiebbare Baugruppen (2) einsetzbar sind.

5. Baugruppenträger nach einem der vorherigen Ansprüche,
**dadurch gekennzeichnet,**
daß auf einer Seite der Tragwand (5) nur ein Boden (4) in der unteren Ebene angeordnet ist, daß das darüberliegende Formteil (1) zum unteren im Querschnittsprofil spiegelsymmetrisch angeordnet ist, daß dadurch der einseitig vorstehende Boden des oberen Formteils in der oberen Führungsebene liegt, daß zwischen den beiden Böden (4) Baugruppen (2) mit großer Einbauhöhe einsetzbar sind, daß auf der anderen Seite der Tragwand (5) mehrere Böden (4) in übereinanderliegenden Ebenen angeordnet sind, zwischen denen Baugruppen (2) von niedrigerer Bauhöhe einsetzbar sind.

6. Baugruppenträger nach einem der vorhergehenden Ansprüche,
**dadurch gekennzeichnet,**
daß das Formteil (1) als Strangpreßprofil ausgebildet ist.

7. Baugruppenträger nach einem der vorhergehenden Ansprüche,
**dadurch gekennzeichnet,**
daß das Formteil (1) im Querschnitt hakenartig, zu den Führungsnuten (6) parallel verlaufende Befestigungskanäle (9) aufweist, und daß zwischen den beiden übereinanderliegenden Formteilen (1) eine Verstärkungsplatte (8) eingesetzt ist, die mit abgewinkelten Längskanten den Befestigungskanälen (9) angepaßt und in diese eingeschoben ist.

8. Baugruppenträger nach Anspruch 7,
**dadurch gekennzeichnet,**
daß die Verstärkungsplatte (8) aus einem u-förmig gebogenen Blech besteht, und daß die Befestigungskanäle (9) im Eckbereich zwischen der Tragwand (5) und den einander zugewandten Böden (4) der Formteile (1) angeordnet sind.

9. Baugruppenträger nach Anspruch 7 oder 8,
**dadurch gekennzeichnet,**
daß die beiden Formteile (1) mit der Rückwandverdrahtungsplatte (3) und der Verstärkungsplatte (8) eine in sich stabile Einheit für eine elektrische Funktionseinheit bilden, die in ein Gehäuse (10) des Baugruppenträgers einsetzbar ist.

10. Baugruppenträger nach Anspruch 9
**dadurch gekennzeichnet,**
daß das Gehäuse (10) auf seiner Ober- und Unterseite als Begrenzungswände (11) flache Strangpreßteile aufweist, die mit quer zur Einschubrichtung verlaufenden, teilweise offenen eingepreßten Befestigungskanälen (9) versehen sind, in die Befestigungselemente für blechartige Seitenwände (12) des Gehäuses (10) einsetzbar sind.

11. Baugruppenträger nach Anspruch 10
**dadurch gekennzeichnet,**
daß als Befestigungselemente Ziehnieten (15) dienen, die sich in den Befestigungskanälen (9) verklemmen.

12. Baugruppenträger nach einem der vorhergehenden Ansprüche,
**dadurch gekennzeichnet,**
daß das Gehäuse (10) rückseitig nockenartige und hackenartige Vorsprünge (13) aufweist, mit denen das Gehäuse (10) in entsprechende Querprofilteile eines Halterahmens eingreift.

13. Baugruppenträger nach Anspruch 12
**dadurch gekennzeichnet,**
daß der hakenartige Vorsprung (13) im oberen Bereich des Gehäuses (10) angeordnet ist und eine waagerechte Befestigungsschiene (14) des Haltrahmens von oben hintergreift, und daß von der Vorderseite her eine Spannschraube des Gehäuses gegen die Befestigungsschiene (14) gedrückt ist.

14. Baugruppenträger nach Anspruch 12 oder 13
**dadurch gekennzeichnet,**
daß in einer Telekommunikationsvermittlungsanlage Funktionseinheiten unterschiedlicher Übertragungsstufen nebeneinander am Halterahmen befestigbar sind.
